# EUROPÄISCHE PATENTANMELDUNG

(11) **EP 0 881 197 A2**
(43) Veröffentlichungstag der Anmeldung: **02.12.1998**
(21) Anmeldenummer: 98106672.3
(22) Anmeldetag: 11.04.1998
(51) Int. Cl.: C03C 17/00

(54) **Verfahren und Vorrichtung zur Beschichtung von Kunststoff- oder Glasbehältern mittels eines PCVD-Beschichtungsverfahrens**

(30) Priorität: 27.05.1997 DE 19722205
(71) Anmelder: Leybold Systems GmbH, D-63450 Hanau am Main (DE)
(72) Erfinder: Nauenburg, Klaus, Dr., 63456 Hanau (DE); Anderle, Friedrich, 63452 Hanau (DE); Dicken, Wilfried, 63607 Wächtersbach (DE); Henrich, Jürgen, 63694 Limeshain (DE); Grünwald, Heinrich, Dr., 61194 Niddatal (DE); Liehr, Michael, Dr., 36325 Feldatal (DE); Beckmann, Rudolf, 63454 Hanau (DE)

(57) **Zusammenfassung**

Bei einem Verfahren zur Beschichtung der Außenwand eines Behälters, vorzugsweise eines aus für Gase und gasförmige Stoffe permeablen Kunststoffes, wird mittels eines vakuumgestützten plasmachemischen Verfahrens eine für Gase nicht permeable Barriereschicht abgeschieden. Zur Unterstützung der Plasmaentladung wird in die Vakuumprozeßkammer elektromagnetische Strahlung eingestrahlt und auf der Behälteraußenwand eine den Durchtritt gasförmiger und/oder flüssiger Stoffe hemmende Polymerschicht abgeschieden. Die elektromagnetische Strahlung wird über eine Antennenanordnung, welche in den Plasmaprozeßraum hineinragt, in diesen eingestrahlt. In den beschichteten Behältern, welche z. B. aus Kunststoff hergestellt sind und eine verschließbare Öffnung aufweisen, werden vorzugsweise flüchtige Substanzen, wie z. B. Kraftstoffe, gasabgebende Flüssigkeiten oder Aromen enthaltende Flüssigkeiten transportiert oder gelagert, wobei eine Permeation dieser flüchtigen Substanzen durch die Behälterwandung hindurch von der Barriereschicht verhindert wird.

## Beschreibung

Die Erfindung betrifft einen Behälter mit einer den Durchtritt von gasförmigen und/oder flüssigen Stoffen durch die Behälterwandung hemmenden Beschichtung, ein Verfahren zu seiner Herstellung und eine Vorrichtung zur Durchführung des Verfahrens.

Behälter zur Lagerung und Konservierung von gasförmigen und/oder flüssigen Stoffen sind als solche bekannt. Derartige Behälter bestehen vorzugsweise aus Glas oder Blechzuschnitten bzw. aus Kunststoffen, wobei letztere den Vorteil haben, gegenüber den vorgenannten ein deutlich geringeres Gewicht sowie eine höhere Resistenz gegenüber Umwelteinflüssen aufzuweisen. Als nachteilig hat sich bei derartigen Kunststoffbehältern erwiesen, daß bei den verwendeten Kunststoffmaterialien ein Gasaustausch zwischen dem in dem Behälter befindlichen Gut und dem Behälteraußenraum durch Diffusion auftritt. Grund hierfür ist, daß die verwendeten Kunststoffe die Diffusion der Gase, wie z. B. Sauerstoff, Kohlendioxid oder Wasserdampf sowie von sonstigen flüchtigen Substanzen wie Kraftstoffen oder Aromen und Duftstoffen ermöglichen. Insbesondere ist mit den derzeitig verfügbaren Kunststoffbehältern die gewünschte Langzeitbeständigkeit des Behältergutes nicht gewährleistet.

Zur Innenbeschichtung von Hohlbehältern aus Kunststoff oder Metall mit inerten, impermeablen, glasartigen Schichten wird in WO 95/21948 vorgeschlagen, anorganische Substanzen unter Vakuum im Innern der Hohlbehälter unter Einwirkung eines Plasmas zu verdampfen, wobei eine gewisse Aufheizung der Behälterwand durch das Plasma aus Gründen besserer Haftung erwünscht ist. Nachteilig ist der hohe apparative Aufwand für das Einbringen und Bewegen der Verdampferquelle.

Alternativ wird in WO 95/22413 vorgeschlagen, Schichten derselben Art im Innern von Hohlbehältern aus Kunststoff oder Metall mittels Plasmapolymerisation herzustellen, wobei die Prozeßdrücke innerhalb und außerhalb der Behälter unabhängig voneinander kontolliert werden sollen. Die beiden vorgenannten Verfahren haben speziell das Beschichten der Innenseite der Hohlbehälter zum Ziel, was im Falle von Medizin- oder Lebensmittelbehältern weniger erwünscht ist, da das reaktive Verhalten der so hergestellten Schichten gegenüber den unterschiedlichsten Inhaltsstoffen noch wenig bekannt ist.

In US 5,374,314 wird hingegen ein Verfahren zur Außenbeschichtung von Hohlkörpern vorgeschlagen, bei dem durch ein erstes, elektrisch leitfähig gemachtes Gas innerhalb des Hohlkörpers ein elektrisches Potential von einer ebenfalls innerhalb des Hohlkörpers angeordneten Elektrode homogen auf die Innenseite der Hohlkörper aufgeprägt wird. Hierdurch wird ein Beschichtungsprozeß an der Außenseite bewirkt, der unter Verwendung eines zweiten Gases, das Ladungsträger enthält, unterstützt wird. Von Nachteil ist allerdings der auch hier erhebliche apparative Aufwand zur Durchführung des Verfahrens.

Der Erfindung liegt die Aufgabe zugrunde, einen Behälter der gattungsgemäßen Art so weiterzubilden, daß dessen Wandung eine gegenüber den bekannten Behältern geringere Permeabilität aufweist. Weiterhin soll ein Verfahren zur Herstellung eines derartigen Behälters und eine Vorrichtung zur Durchführung des Verfahrens geschaffen werden.

Die Aufgabe wird erfindungsgemäß mit einem Behälter nach den Merkmalen des Patentanspruchs 3, hergestellt nach einem erfindungsgemäßen Verfahren gemäß Patentanspruch 1 mittels einer erfindungsgemäßen Vorrichtung gemäß Patentanspruch 2 gelöst.

Gemäß Patentanspruch 1 ist vorgesehen, die Behälterwandung, vorzugsweise die Außenwandung des Behälters, mittels eines plasmagestützten Beschichtungsverfahrens, vorzugsweise des PCVD-Verfahrens zu beschichten. Hierzu wird der mindestens eine Öffnung aufweisende Hohlkörper in eine Beschichtungskammer eingebracht und die zu beschichtende äußere Begrenzungsfläche vakuumdicht von der Innenwandung des Hohlkörpers abgedichtet. Der Behälteraußenraum wird von den Wandungen einer Beschichtungskammer nach außen begrenzt. Nach Evakuierung der Beschichtungskammer wird in den Behälteraußenraum über Gaseinlässe ein Plasmaprozeßgas eingelassen, welches mittels über Antennen in den Behälteraußenraum geleiteter elektromagnetischer Strahlung in den Plasmazustand überführt wird. Während der gesamten Beschichtungsdauer herrscht in dem Behälterinnenraum ein Gasdruck, welcher eine Plasmazündung verhindert. Hierdurch wird vorteilhaft selektiv ausschließlich die äußere Behälterwandung mit einer PCVD-abgeschiedenen Schicht bedeckt. Der Druck innerhalb des Behälters ist im überwiegenden Verlauf der Prozeßzeit höher als außerhalb des Behälters und beträgt vorzugsweise 900 mbar - 1100 mbar. Der Druck außerhalb des Behälters beträgt zwischen 0,005 mbar und 50 mbar, bevorzugt zwischen 0,05 mbar und 10 mbar. Das Plasma außerhalb des Behälters kann beispielsweise auch durch Einstrahlung von Mikrowellen in den Plasmaprozeßraum erzeugt und für eine vorgegebene Zeit aufrecht erhalten werden. Die bevorzugte Mikrowellenfrequenz hierfür beträgt 2,45 GHz.

Hierbei ist eine ausgeprägt radialsymmetrische elektrische Feldverteilung der eingestrahlten Mikrowellen zur Erzielung einer gleichmäßigen Beschichtung von Vorteil. Zur Einspeisung von Mikrowellen ist beispielsweise ein Wellenleiter vorgesehen, der aus einem rohr- oder stabförmigen Innenleiter und einem koaxial hierzu angeordneten Metallzylinder besteht. Hierzu wird vorgeschlagen, den Außenleiter des Wellenleiters auch außerhalb des Hohlkörpers selbst anzuordnen.

Weiterhin ist alternativ vorgesehen, die Mikrowellen von einer außerhalb der Behälter angeordneten Antennenvorrichtung, vorzugsweise von einer aus der Literatur bekannten Lisitano-Antenne, in Richtung der Hohlkörperaußenwand abzustrahlen. Bei allen genannten Mikrowellenanordnungen ist eine vorzugsweise nichtresonante Betriebsweise vorgesehen. Durch Variation der Länge der Beschichtungskammer ist im Bedarfsfall ein resonanter Mikrowellenbetrieb einstellbar.

Als vorteilhaft hat sich weiterhin erwiesen, die Mikrowellen gepulst abzustrahlen und/oder zusätzlich zur Einstrahlung von Mikrowellen eine elektromagnetische Strahlung einer Frequenz im Bereich von 10 kHz bis 450 kHz in den Plasmaprozeßraum als Dipol-, Quadropol- oder Oktopolfeld einzustrahlen.

Zur Vermeidung der thermisch bedingten Verformung oder sonstiger Beeinträchtigung der Behälter während der Beschichtungsdauer werden diese durch ein ins Behälterinnere eingeleitetes Kühlmedium gekühlt. Hierzu wird ein gasförmiges Kühlmedium, vorzugsweise Luft in das Behälterinnere eingeleitet, wobei die Mikrowellenantenne oder eine Radiowellenantenne als Kühlmediumeinlaß dienen. Alternativ ist vorgesehen, daß das Kühlmedium aus einer im wesentlichen unpolaren, Mikrowellen und Radiowellen nicht absorbierenden Flüssigkeit besteht. Bei Einstrahlung von Radiowellen im MHz- oder KHz-Bereich durch außerhalb des Behälters angeordneten Antennen kann die Kühlflüssigkeit auch Wasseranteile enthalten.

Zum Lösen des beschichteten Behälters von der Beschichtungsvorrichtung nach dem Belüften der Beschichtungskammer wird ein kurzer Gasdruckstoß über die Öffnung des Hohlkörpers in diesen eingeleitet, wodurch der Hohlkörper ohne weiteres von der Beschichtungsvorrichtung gelöst wird. Zur Abstützung des Hohlkörpers gegen Verformung während der Beschichtungsdauer sind innerhalb der Beschichtungskammer Halteelemente vorgesehen, mit welchen der Hohlkörper formstabil gehalten wird.

Bei Einstrahlung von Radiowellen in den Plasmaprozeßraum von einer innerhalb des Behälters angeordneten Antenne aus weisen diese eine Frequenz von 13,56 MHz oder ein Mehrfaches hiervon auf.

Von außerhalb des Behälters eingestrahlte Radiowellen werden über eine außerhalb der Hohlkörper angeordneten Elektrodenanordnung eingestrahlt. Von außerhalb eingestrahlte Radiowellen weisen eine Frequenz von 10 kHz bis 450 kHz, bevorzugt 30 bis 450 kHz, oder von 13,56 MHz oder einem Mehrfachen hiervon auf. Im Falle der Anwendung einer Frequenz im MHz-Bereich wird eine um den Behälter gewundene Spule zur Abstrahlung der Strahlung vorgeschlagen.

Als schichtbildende Prozeßgase sind Tetraethoxisilan oder Tetramethoxisilan oder Mischungen, die diese Substanzen enthalten, vorgesehen. Alternativ sind als schichtbildendes Gas Tetraisopropoxiothotitanat oder Mischungen, die diese Substanz enthalten, vorgesehen. Weiterhin werden alternativ als schichtbildende Gase vorgeschlagen: Tetramethyldisiloxan, Vinyltrimethoxysilan, Vinyltrimethylsilan, Octamethylcyclotetrasiloxan, Divinyltetramethyldisiloxan oder Mischungen, die diese Substanzen enthalten. Die abzuscheidenden bzw. abgeschiedenen Schichten sind kohlenstoffarme, im wesentlichen Silizium und Sauerstoff enthaltende Schichten oder kohlenstoffreiche, silikonartige Schichten aus einem der vorgenannten Gasgemische.

Weiterhin ist vorgesehen, die hergestellten Schichten durch ein nachfolgend appliziertes Plasma, in das wenigstens eine Hydroxiverbindung, vorzugsweise Ethanol oder Methanol, eingeleitet ist, nachzubehandeln. Durch das die Hydroxiverbindung enthaltende Plasma wird die Oberfläche der abgeschiedenen Schicht in einer Schichttiefe bis von 2 nm - 3 nm modifiziert.

Die Erfindung wird anhand von in Figuren dargestellten, besonders bevorzugten Ausführungsbeispielen näher beschrieben. Es zeigen:
- Fig. 1: eine erfindungsgemäße Beschichtungsvorrichtung zum Abscheiden von PCVD-Schichten auf Behälteraußenflächen im Längsschnitt nach einem ersten Ausführungsbeispiel,
- Fig. 2: eine Querschnittsansicht eines Dichtverschlusses einer Beschichtungsvorrichtung nach einem zweiten Ausführungsbeispiel,
- Fig. 3: eine Aufsicht auf die in Fig. 2 eingezeichnete Schnittebene A-A',
- Fig. 4a: ein drittes Ausführungsbeispiel eines Dichtverschlusses für eine erfindungsgemäße Beschichtungsvorrichtung in Freigabeposition und
- Fig. 4b: den in Fig. 4a gezeigten Dichtverschluß in Verriegelungsposition.

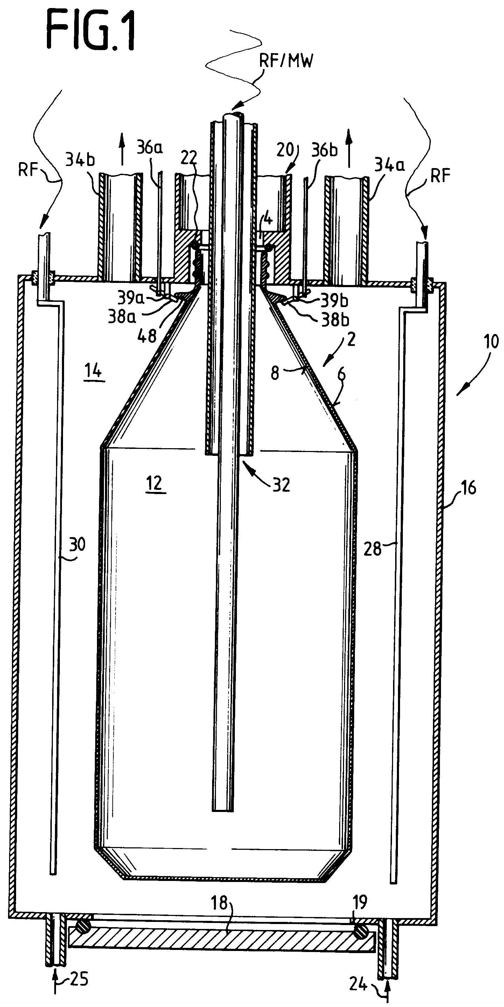

In Fig. 1 ist eine Beschichtungsvorrichtung 1 dargestellt, mittels welcher die Außenflächen 6 von einem eine Öffnung 4 aufweisenden Behälter 2 durch ein plasmagestütztes PCVD-Verfahren zu beschichten. Die Beschichtungsvorrichtung 1 umfaßt eine evakuierbare Beschichtungskammer 10, welche über in die Kammerwand 16 eingelassene Abpumpstutzen 34a,34b und mittels in der Fig. 1 nicht dargestellter Vakuumpumpen evakuierbar ist. Zum Beschicken der Beschichtungskammer 10 mit den Behältern 2 weist diese eine Öffnung 17 auf, welche über einem Deckels 18 verschließbar ist, der auf Dichtelementen 19 an der Kammerwand 16 anliegt und die Beschichtungskammer 10 vakuumdicht abschließt.

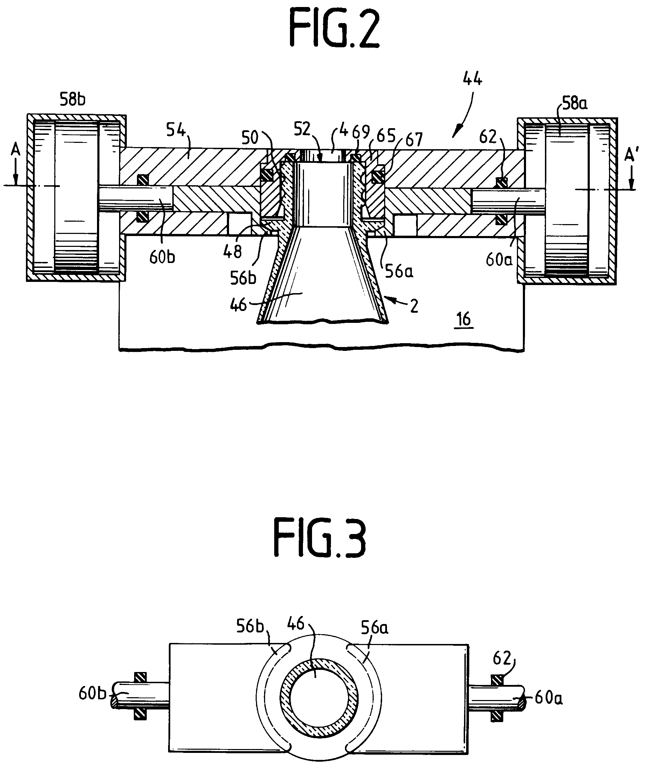

Zum Beschichten der Außenfläche 6 des Behälters 2 wird dieser über die Öffnung 17 in die Beschichtungskammer 10 eingebracht und die Beschichtungskammer 10 anschließend mit dem Deckel 18 vakuumdicht verschlossen. Der Behälter 2 ist öffnungsseitig konisch ausgebildet und weist endseitig eine Öffnung 4 mit einem Außengewinde 50 auf (siehe Fig. 2). Der Behälter 2 ist mit seiner Öffnung 4 stirnseitig in einem Dichtkopf 20 angeordnet und liegt mit seiner stirnseitigen Dichtfläche 52 umlaufend gegen ein Dichtungselement 22 an. Um einen gegenüber dem Innenraum der Beschichtungskammer 10 vakuumdichten Übergang zum Behälterinnenraum 12 zu gewährleisten, wird der Behälter 2 mittels einer auf einem Behälter 2 angeformten, vorzugsweise umlaufenden Kragen 48 ausgeübten Verriegelungskraft gegen das Dichtungselement 22 gepreßt.

Zum Zünden eines Plasmas im Behälteraußenraum 14 wird in diesem über Gaseinlässe 24,25 (siehe Fig. 1) ein Prozeßgas eingelassen, wobei der für die Zündung des Plasmagases und den Betrieb des Plasmas benötigte Gasdruck eingestellt wird. Zum Zünden des Plasmas wird elektromagnetische Strahlung über in den Plasmaprozeßraum 14 hineinragende und von der Kammerwand 16 elektrisch isolierte angeordnete Antennen 28,30 eingeleitet. In dem Behälterinnenraum 12 ist ein Gasdruck eingestellt, der außerhalb des Zünddruckbereiches des in dem Behälterinnenraum 12 befindlichen Gases liegt. Hierdurch wird bewirkt, daß das Plasma ausschließlich in dem Behälteraußenraum 14 zündet und die plasmagestützte, plasmachemische Schichtabscheidung ausschließlich auf der Außenfläche 6 des Behälters 2 erfolgt.

Alternativ oder zusätzlich zu den Antennen 28,30 ist eine Wellenleiteranordnung 32 vorgesehen, welche im wesentlichen koaxial durch die Behälteröffnung 4 in den Behälterinnenraum 2 hineinragt. Mittels des Wellenleiters 32 kann die zum Zünden und Betrieb des Plasmas benötigte elektromagnetische Energie in Form von Mikrowellen dem Plasmaprozeßraum 14 zugeführt werden. Die Mikrowellenfrequenz liegt hierbei im GHz-Bereich und beträgt üblicherweise 2,45 GHz.

Zur Kühlung der sich während des Beschichtungsprozesses aufheizenden Behälterwandung 5 wird über den koaxial ausgebildeten Wellenleiter 32 ein Kühlgas in den Behälterinnenraum 12 eingeleitet, wodurch eine thermisch bedingte Verformung des Behälters 2 aufgrund des zwischen dem Behälterinnenraum 12 und dem Behälteraußenraum 14 herrschenden Druckunterschieds verhindert wird.

Nach erfolgter Beschichtung wird der Plasmaraum 14 über die Gaseinlasse 24,25 belüftet und der Behälter 2 durch die Öffnung 17 entnommen.

In Fig. 2 ist ein Dichtverschluß 44 zum Verriegeln des Behälters 2 nach einem zweiten Ausführungsbeispiel dargestellt. Zum Verriegeln des Behälters 2 an der Beschichtungsvorrichtung während des Beschichtungsprozesses wird der Behälterkopf 40 mit seinem Außengewinde 50 in ein im Kopfteil 54 der Beschichtungsvorrichtung angeordneten Einsatzteil 65 eingesetzt. Zum dichtenden Verschließen des Behälterinnenraumes 12 gegenüber dem Behälteraußenraum 14 wird der Behälter 2 mittels zweier gegeneinander verschiebbarer und einander diametral gegenüberliegend angeordneter Schieber 56a,56b mit der stirnseitig umlaufenden Dichtfläche 52 gegen das Einsatzteil 65 gepreßt, wobei die Schieber 56a,56b gegen die schräge Unterfläche des Behälterkragens 48 gleiten und dieser mit dem Behälter 2 in eine in Richtung des Kopfteils 54 gerichtete Vorzugsrichtung verschoben werden. Hierbei wird die Dichtfläche 52 gegen das umlaufende, im Einsatzteil 65 in eine Ringnut eingelegt Dichtungselement 69 vakuumdichtend gedrückt. Die Schieber 56a,56b werden hierbei durch je einen Druckluftzylinder 58a,58b gegenläufig zueinander bewegt. Zum Lösen des Behälters 2 aus dem Dichtverschluß 44 werden die Schieber 56a,56b von dem Behälter 2 weg verfahren, wodurch der Behälter 2 ohne weitere Maßnahmen aus dem Einsatzteil 65 herausfällt. Zum Lösen des Behälters 2 kann durch einen auf die Öffnung 4 gerichteten Druckstoß die Trennung des Behälters 2 von dem Kopfteil 54 beschleunigt werden.

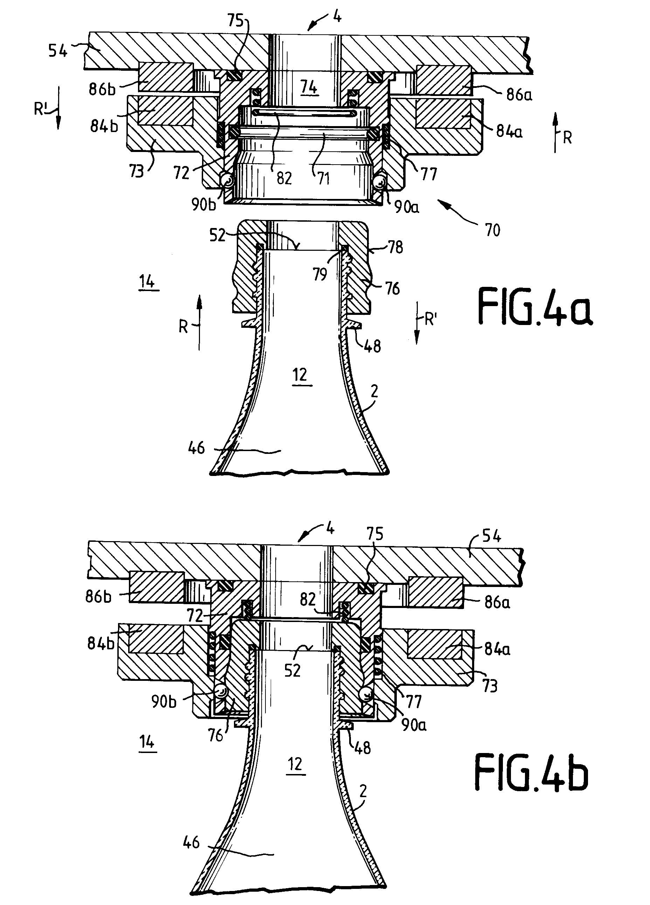

In den Fig. 4a und 4b ist ein weiterer Dichtverschluß 70 in der Verriegelungsposition (Fig. 4b) und in einer Zuführ- bzw. Entnahmeposition (Fig. 4a) dargestellt. Der Dichtverschluß 70 besteht im wesentlichen aus einer stationär an dem Kopfteil 54 angeordneten Adapteraufnahme 72. Die Adapteraufnahme 72 besitzt eine Durchgangsöffnung 74, welche im wesentlichen deckungsgleich zu der in dem Kopfteil 54 eingelassenen Öffnung 4 angeordnet ist. Zum Verriegeln eines zu beschichtenden Behälters 2 wird auf den Behälterkopf 40 ein Adapter 76 mit dem Außengewinde 50 des Behälters 2 verschraubt. Stirnseitig liegt der Adapter 76 mit einem umlaufenden Dichtungselement 79 auf der stirnseitigen Dichtfläche 52 des Behälters 2 auf (siehe Fig. 4a). Mittels in den Zeichnungen nicht dargestellter Transportvorrichtungen wird der Behälter 2 mit aufgesetztem Adapter 76 in die Adapteraufnahme in der in Fig. 4a dargestellten Beladerichtung R eingesetzt, wobei der Adapter 76 mit seiner Stirnfläche eine in der Adapteraufnahme 72 eingelassene Ringfeder in seiner Endposition zusammendrückt. Die Außenmantelfläche des Adapters 76 liegt dichtend an einem umlaufenden Dichtungselement 71, welches in der Adapteraufnahme 72 in einer Nut fixiert ist, an. Da die Adapteraufnahme 72 gleichzeitig mit dem die Öffnung 4 umlaufenden Dichtungselement aufliegt, ist der Behälteraußenraum 14 von dem Behälterinnenraum 12 vollständig dichtend abgetrennt.

Zum Verriegeln des Behälters 2 in Bezug zum Kopfteil 54 wird, wie in Fig. 4b dargestellt, ein die Adapteraufnahme 72 umgebender und axial auf dieser verschiebbar gelagerter Verschlußring 73 von dem Kopfteil 54 durch eine elektromagnetisch ausgeübte Kraft wegbewegt. Hierzu sind in den Verschlußring 73 Magnetkörper 84a,84b, z. B. Permanentmagnete, eingesetzt, welche im Zusammenwirken mit in dem Kopfteil 54 angeordneten Elektromagneten 86a,86b positioniert werden können. In ihrer in der Fig. 4b dargestellten Verriegelungsposition sind die Elektromagnete 86a und 86b derartig aktiviert, daß der Verschlußring 73 mit Unterstützung der zwischen dem Verschlußring 73 und der Adapteraufnahme 72 angeordneten Feder 77 in der in Fig. 4b gezeigten Verriegelungsposition gehalten wird. Hierdurch werden in der Adapteraufnahme 76 in Kugellagerungen angeordnete Sperrkugeln 90a,90b in die in dem Adapter 76 ausgeformten Kulissen gepreßt und verriegeln den Adapter 76 in der Adapteraufnahme 72. Anschießend wird der Behälteraußenraum wie vorstehend beschrieben evakuiert, wobei der Behälterinnenraum 12 mit einem kühlenden Medium durchströmt wird.

Nach erfolgter Beschichtung des Behälters 2 wird der Adapter 76 durch eine auf das Kopfteil 54 gerichtete Bewegung des Verschlußringes 73 entriegelt. Der entriegelte Adapter wird durch die vorgespannte Feder 82 aus der Adapteraufnahme 72 herausgedrückt, um anschließend weitertransportiert zu werden. Das Ablösen des Behälters 2 aus dem Dichtverschluß 70 kann hierbei durch einen durch die Öffnungen 4,74 in den Behälterinnenraum 12 gerichteten Druckstoß eines Gases unterstützt werden. In der Entriegelungsposition sind die Elektromagnete 86a und 86b derartig aktiviert, daß zwischen den Permanentmagneten 84a bzw. 84b und den Elektromagneten 86a einerseits und 86b andererseits eine anziehende elektromagnetische Kraft ausgeübt wird.

### Bezugszeichenliste

- 1: Beschichtungsvorrichtung
- 2: Behälter, Hohlkörper
- 4: Öffnung
- 5: Behälterwand
- 6: Außenfläche
- 8: Innenfläche
- 10: Beschichtungskammer
- 12: Behälterinnenraum
- 14: Behälteraußenraum, Plasmaprozeßraum
- 16: Kammerwand
- 17: Öffnung
- 18: Deckel
- 19: Dichtungselement
- 20: Dichtkopf
- 22: Dichtungselement
- 24: Gaseinlaß
- 25: Gaseinlaß
- 26: Gaseinlaß
- 28: Antenne
- 30: Antenne
- 32: Wellenleiter
- 34a,b: Abpumpstutzen
- 36a,b: Betätigungsstange
- 38a,b: Verriegelungselement
- 39a,b: Wipplager
- 40: Behälterkopf
- 42: Öffnung
- 44: Dichtverschluß
- 46: Flaschenhals
- 48: Behälterkragen
- 50: Außengewinde
- 52: Dichtfläche
- 54: Kopfteil
- 56a,b: Schieber
- 58a,b: Druckluftzylinder
- 60a,b: Kolbenstange
- 62: Dichtungselement
- 65: Einsatzteil
- 67: Dichtungselement
- 69: Dichtungselement
- 70: Dichtverschluß
- 71: Dichtungselement
- 72: Adapteraufnahme
- 73: Verschlußring
- 74: Öffnung
- 75: Dichtungselement
- 76: Adapter
- 77: Feder
- 78: Dichtfläche
- 79: Dichtungselement
- 82: Feder
- 84a,b: Magnetkörper
- 86a,b: Elektromagnet
- 90a,b: Sperrkugel
- R: Beladerichtung
- R': Entnahmerichtung

## Patentansprüche

1. Verfahren zur Beschichtung der Begrenzungsflächen eines Hohlkörpers, vorzugsweise eines mindestens eine verschließbare Öffnung aufweisenden Hohlkörpers, mittels Plasmabeschichtung, vorzugsweise mittels plasmachemischer Abscheidung unter Einwirkung eines Plasmas auf die zu beschichtende Begrenzungsfläche des Hohlkörpers, **dadurch gekennzeichnet**, daß das Verfahren folgende Verfahrensschritte umfaßt:
a) Einbringen des zu beschichtenden Hohlkörpers (2) in eine evakuierbare Beschichtungskammer (10);
b) Verschließen und anschließendes Evakuieren der Beschichtungskammer (10);
c) Einlassen eines Plasmaprozeßgases oder eines Prozeßgasgemisches in den Plasmaprozeßraum (14), wobei ein für die Zündung und die Betreibung des Plasmas vorgesehener Gasdruck ausschließlich im Bereich der zu beschichtenden Begrenzungsfläche (6), vorzugsweise im Behälteraußenbereich (14) zur vorzugsweisen, ausschließlichen Beschichtung der Behälteraußenwandfläche (6) zur Durchführung der Beschichtung eingestellt wird;
d) Zündung des Plasmas und Aufrechterhaltung der Plasmaentladung durch Einstrahlung von elektromagnetischer Strahlung in den Plasmaprozeßraum (14) für eine vorbestimmte Zeitdauer, wodurch auf der zu beschichtenden Fläche (6) eine vorzugsweise den Gas- und Flüssigkeitsdurchtritt von in den Innenraum (12) des Behälters (2) einzubringenden gasförmigen und/oder flüssigen Stoffen in den Außenraum (14) hemmende Polymerschicht abgeschieden wird;
e) Abschalten der elektromagnetischen Strahlung und anschließendes Belüften der Beschichtungskammer (10) und zur Entnahme des beschichteten Hohlkörpers (2).

2. Vorrichtung zur Durchführung des Verfahrens nach Anspruch 1 mit einer evakuierbaren Beschichtungskammer (10), welche mindestens eine zum Ein- und Ausbringen des zu beschichtenden Hohlkörpers (29 verschließbare Öffnung (42), mindestens einen Gaseinlaß (24,25) zum Einleiten von Prozeßgas in den Plasmaprozeßraum (14) und eine Antennenanordnung (28,30) zur Einspeisung elektromagnetischer Strahlung in den Plasmaprozeßraum, mittels welcher das Plasmagas zündbar und die Plasmaentladung betreibbar ist, aufweist, und wobei der Behälterinnenraum (12) vorzugsweise mittels Dichtungselementen (22,667,69,71) gasdicht von dem Behälteraußenraum (14) abdichtbar ist.

3. Behälter mit mindestens einer verschließbaren Öffnung (4) und einer auf den Begrenzungsflächen (6,8) des Behälters abgeschiedenen, den Durchtritt von gasförmigen und flüssigen Stoffen von dem Behälterinnenraum (12) in den Außenraum und/oder von dem Außenraum in den Behälterinnenraum (12) hemmenden Schicht, welche mittels eines plasmagestützten, vorzugsweise mittels eines plasmachemischen Beschichtungsverfahrens hergestellt ist, wobei die Schicht auf der Außenfläche (6) des Behälters aufgebracht ist.
